# EUROPÄISCHE PATENTSCHRIFT

(11) **EP 3 057 388 B1**
(45) Veröffentlichungstag und Bekanntmachung des Hinweises auf die Patenterteilung: **29.03.2017**
(21) Anmeldenummer: 15305210.5
(22) Anmeldetag: 12.02.2015
(51) Int. Cl.: H05K 9/00, H01M 2/10, H01M 8/24

(54) **Gehäuse für Hochvoltkomponenten**
Housing for high voltage components
Boîtier pour composants haute tension

(43) Veröffentlichungstag der Anmeldung: 17.08.2016
(73) Patentinhaber: Nexans, 75008 Paris (FR)
(72) Erfinder: Grüner, Claudius, 92699 IRCHENRIETH (DE); Hoch, Marina, 92685 FLOSS (DE)
(74) Vertreter: Godard, Evelin

(56) Entgegenhaltungen:
- DE-T5-112006 002 637

## Beschreibung

Die Erfindung bezieht sich auf eine Anordnung für in einem Kraftfahrzeug befindliche Hochvoltkomponenten gemäß dem Oberbegriff des Patentanspruchs 1.

In Elektro- und Hybridfahrzeugen kommen eine Vielzahl von elektrischen und elektronischen Komponenten für den Fahrzeugantrieb und andere Aufgaben zum Einsatz. Die Antriebsenergie wird von Traktionsbatterien bereitgestellt, welche sehr hohe Betriebsspannungen, typischerweise bis zu mehreren hundert Volt, erzeugen. In Elektrofahrzeugen beträgt die Betriebsspannung beispielsweise bis zu 600 V.

Um Personen vor dem Kontakt mit diesen hohen Spannungen zu schützen, gelten für Elektro- und Hybridfahrzeuge besondere Sicherheitsanforderungen. Um den Berührungsschutz zu gewährleisten, sind in solchen Fahrzeugen besondere Schutzvorrichtungen vorhanden. In Elektrofahrzeugen bestehen diese unter anderem aus einer Isolationsüberwachung. Die Isolationsüberwachung überwacht sämtliche elektrischen Komponenten im Fahrzeug auf Beschädigungen oder Fehlfunktionen. Sie besteht aus Hochvoltkomponenten, welche sämtliche Hochvoltleitungen und Hochvoltsysteme überwachen. Je nach Größe des gemessenen Fehlstromes wird der Fahrzeugführer entweder mittels einer Kontrolleuchte auf den Fehler aufmerksam gemacht, oder das gesamte Fahrzeug wird spannungslos geschaltet, damit kein Strom mehr fließen kann.

Die zur Isolationsüberwachung notwendigen Komponenten sind Hochvoltkomponenten. Sie sind in einer sogenannten Isowächter-Box untergebracht. Die Isowächter-Box besteht aus einem geschlossenen, elektrisch leitfähigen Gehäuse, welches die enthaltenen Hochvoltkomponenten abschirmt. Das Gehäuse hat in seiner Wandung mehrere Bohrungen, welche den Anschluß von abgeschirmten elektrischen Leitungen an die Hochvoltkomponenten erlauben, ohne daß die Abschirmung unterbrochen wird. Die Schirme von Gehäuse und Leitungen werden im Bereich der Bohrungen elektrisch verbunden, beispielsweise über Krallenverschraubungen. Die Kontaktierbarkeit des Gehäuses erlaubt sowohl den Stromfluß zwischen dem jeweiligen Leitungsschirm und dem Gehäuse als auch den elektrischen Anschluß des Gehäuses an die Fahrzeugmasse, d.h. die Karosserie. Über den Potentialausgleich zwischen dem Gehäuse und der Karosserie wird der Berührungsschutz der Isowächter-Box gewährleistet. Der Berührungsschutz sowie die Dichtigkeit gegen Wasser (kurzzeitiges Eintauchen) und Staub werden durch die Schutzklasse IP67 zusammengefaßt, welcher die Isowächter-Box entsprechen muß. Die Isowächter-Box muß weiterhin bestimmte mechanische und Temperaturanforderungen erfüllen, welche sich aus dem Einsatz in einem Kraftfahrzeug ergeben (Schwingungen, Erwärmung usw.).

Solche bekannten Gehäuse bestehen aus Metall, beispielsweise aus Aluminium. Die Isowächter-Box besteht beispielsweise aus einem quaderförmigen Kasten, welcher mit einem Deckel wasser- und staubdicht verschließbar ist. Solche Aluminiumboxen haben beispielsweise Dimensionen von ungefähr 160 mm × 200 mm × 220 mm, mit einer Wandstärke von ungefähr 5 mm und einem Gewicht von ungefähr 4 kg. Die Bohrungen für die Leitungsanschlüsse werden nach der Herstellung des Gehäuses je nach Bedarf durchgeführt. Das bekannte Gehäuse ist demnach sehr schwer, erfordert eine aufwendige Herstellung und ist teuer. Die meist quaderförmige Form des Gehäuses ist vorgegeben, sodaß sein Einbau an einer passenden Stelle im Kraftfahrzeug vorbereitet werden muß.

Aus der DE 11 2006 002 637 T5 geht ein Gehäuse zur Aufnahme eines Brennstoffzellenstapels hervor, das aus einem Harz und aus elektromagnetische Wellen dämpfendem Material besteht. Das elektromagnetische Wellen dämpfende Material kann ein leitfähiges Material sein, und zwar beispielsweise ein Aluminiumfüllstoff oder ein Grafitfüllstoff einer Schuppenstruktur oder eine dünne Aluminiumplatte. Das Gehäuse hat Öffnungen, welche der Entlüftung dienen.

Der Erfindung liegt die Aufgabe zugrunde, eine Anordnung mit einem Gehäuse für Hochvoltkomponenten anzugeben, welches die oben genannten elektrischen und mechanischen Anforderungen erfüllt, ein geringes Gewicht aufweist und ohne besonderen Herstellungsaufwand in der gewünschten Form herstellbar ist.

Diese Aufgabe wird entsprechend den kennzeichnenden Merkmalen des Patentanspruchs 1 gelöst.

Die Verwendung von mit metallischen Partikeln gefülltem Kunststoff zur Herstellung eines Gehäuses für Hochvoltkomponenten hat zahlreiche Vorteile. Gegenstände aus Kunststoff können im Spritzgießverfahren hergestellt werden. Dieses Verfahren erlaubt die vollautomatische, serienmäßige und wiederholgenaue Herstellung von Objekten aus Kunststoff in nahezu jeder beliebigen Form. Der Herstellungsprozeß umfaßt dabei nur wenige Schritte, da Öffnungen und andere zusätzliche Elemente bereits während des Spritzgießens miterzeugt werden können. Dies gilt ebenfalls für mit metallischen Partikeln gefüllte Kunststoffe. Das zu verarbeitende Material kann beispielsweise als Pellets vorliegen, in denen die metallischen Partikel mit dem Kunststoff vermischt sind. Das Gehäuse kann demnach bereits während seiner Herstellung so gestaltet werden, daß seine Form den Gegebenheiten am Einbauort innerhalb des Fahrzeugs optimal angepaßt ist. Die Form kann dabei von der bekannten Quaderform abweichen. Die Einbaustelle muß nicht für den Einbau eines Gehäuses mit einer vorgegebenen Form vorbereitet werden, wie es für ein herkömmliches, metallisches Gehäuse der Fall wäre. Das Gehäuse erfüllt dabei alle an Gehäuse für Hochvoltkomponenten gestellten Anforderungen: mechanische Belastbarkeit, Temperaturbeständigkeit, Berührungsschutz sowie Staub- und Wasserdichtigkeit nach Schutzklasse IP67, Kontaktierbarkeit, Schirmdämpfung und Leitfähigkeit. Weiterhin hat das Gehäuse im Vergleich zu einem metallischen Gehäuse, welches beispielsweise aus Aluminium besteht, ein wesentlich geringeres Gewicht. Seine Material- und Herstellungskosten sind ebenfalls vergleichsweise gering im Verhältnis zu denen eines metallischen Gehäuses.

Ein mit metallischen Partikeln gefülltes Polymer hat den Vorteil, daß dieses genau wie reine Kunststoffe mittels des Spritzgießverfahrens verarbeitet werden kann. Dies ist beispielsweise mit intrinsisch leitfähigen Kunststoffen nicht möglich. Als leitfähiger Zusatz werden metallische Partikel verwendet, da mit diesen, im Gegensatz zu nichtmetallischen Partikeln (beispielsweise aus Kohlenstoff), die erforderlichen Leit- bzw. Schirmdämpfungswerte des Gehäuses erreicht werden können.

Ein Ausführungsbeispiel des Erfindungsgegenstandes ist in den Zeichnungen dargestellt.
Es zeigen:
Fig. 1 eine perspektivische Ansicht eines Gehäuses der Anordnung nach der Erfindung nach einer Ausführungsform.
Fig. 2 das Gehäuse nach Fig. 1 in geöffnetem Zustand.

In den Zeichnungen beziehen sich gleiche Bezugszeichen auf gleiche technische Merkmale.

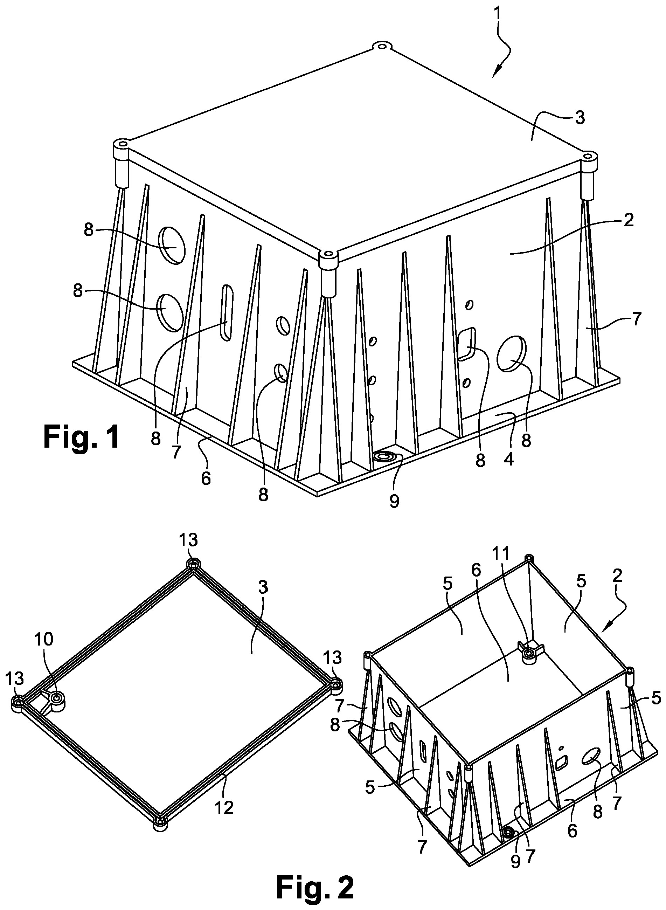

In Fig. 1 ist ein Ausführungsbeispiel eines Gehäuses 1 für Hochvoltkomponenten dargestellt. Das Gehäuse 1 besteht im Wesentlichen aus einem kastenförmigen Unterteil 2 und einem Deckel 3. In Fig. 2 sind der Deckel 3 und das Unterteil 2 zur besseren Übersicht getrennt dargestellt. Das dargestellte Beispiel dient zur Illustration der Erfindung. Wie bereits erwähnt, kann das Gehäuse 1 mit Vorteil praktisch jede beliebige Form aufweisen.

Das kastenförmige Unterteil 2 besteht aus einem Boden 4 und vier Wandungen 5, welche nach einem rechteckigen Grundriß auf dem Boden 4 angeordnet sind. Selbstverständlich können der Grundriß und die Wandungen auch eine beliebige andere Form aufweisen. Die Fläche des Bodens 4 ist größer als die von den Wandungen 5 eingeschlossene Grundfläche. Der rundum überstehende Rand 6 des Bodens 4 kann beispielsweise dafür verwendet werden, das Gehäuse 1 innerhalb des Kraftfahrzeugs zu befestigen und/oder eine leitende Verbindung mit der Karosserie herzustellen, um das Gehäuse 1 mit der Masse zu verbinden. Der Deckel 3 verfügt über eine in einer umlaufenden Nut angebrachte Weichdichtung 12, damit das Gehäuse 1 wasser- und staubdicht geschlossen werden kann.

Nach dem dargestellten Ausführungsbeispiel weisen die Wandungen 5 Stützelemente 7 auf. Sie dienen zur mechanischen Stabilisierung der Wandungen 5. In dem gezeigten Beispiel haben die Stützelemente 7 eine vorteilhafte dreieckige Form. Durch das Vorhandensein der Stützelemente 7 kann eine sehr geringe Wanddicke erreicht werden, ohne daß die mechanische Stabilität des Gehäuses 1 beeinträchtigt wird. Die Wanddicke kann so nur wenige Millimeter betragen, beispielsweise im Bereich von 1 mm bis 4 mm. Durch die geringen Wanddicken kann das Gesamtgewicht des Gehäuses 1 mit Vorteil weiter reduziert werden.

Wie in den Fig. 1 und 2 dargestellt, weisen die Wandungen 5 verschiedenartige Öffnungen 8 auf. Die Öffnungen 8 dienen dazu, elektrische Leitungen an die im Gehäuse 1 enthaltenen Hochvoltkomponenten anzuschließen bzw. die Leitungen ins Gehäuseinnere zu führen. Die elektrischen Leitungen, ebenso wie das Gehäuse 1 selbst, sind elektromagnetisch abgeschirmt. Die Verbindung zwischen dem Gehäuse 1 und dem Schirm der Leitungen muß so gestaltet sein, daß die Gesamtabschirmung nicht unterbrochen wird. Beispielsweise können in die Öffnungen 8 eingespritzte Metallteile oder eingespritzte metallische Kragenhülsen angebracht werden, in welche die Leitungen verschraubt werden, sodaß der Leitungsschirm mit den metallischen Teilen in Kontakt ist. Auch Kabelschuhe, welche mit selbstschneidenden Schrauben oder Gewinden an dem Gehäuse 1 befestigt werden, sind möglich. Weiterhin können die Leitungsschirme an das Gehäuse 1 angelötet oder angeklemmt sein.

Zur Kontaktierung zwischen den beiden Teilen 2 und 3 des Gehäuses 1 ist jeweils eine Gewindebuchse 10 bzw. 11 in dem Unterteil 2 und dem Deckel 3 angebracht, an welche jeweils das Ende eines Verbindungskabels angeschlossen wird. Das Gehäuse 1 besitzt außerdem in seinem Boden 4 mindestens eine weitere Kragenhülse oder Gewindebuchse 9 zur Befestigung des Gehäuses 1 an einem Fahrzeugteil und für den Massekontakt, beispielsweise mittels einer Schraube.

Der für das Gehäuse 1 verwendete Kunststoff ist ein Thermoplast. Geeignete Thermoplaste sind beispielsweise Polyamid, Polypropylen oder Acrylnitril-Butadien-Styrol (ABS). Die metallischen Partikel sind beispielsweise aus Edelstahl, Kupfer oder Zinn. Diese Metalle besitzen eine relativ hohe Leitfähigkeit. Sie liegen beispielsweise in Form von Fasern vor.

## Patentansprüche

1. Anordnung für in einem Kraftfahrzeug befindliche Hochvoltkomponenten, welche ein Gehäuse (1) zur Aufnahme der Hochvoltkomponenten aufweist, das vollständig verschließbar, leitfähig und geeignet ist, die in dem Gehäuse (1) angeordneten Hochvoltkomponenten elektromagnetisch abzuschirmen, und das Öffnungen (8) zum elektromagnetisch verträglichen Anschließen von elektrischen Leitungen an die Hochvoltkomponenten hat, **dadurch gekennzeichnet,**
- **daß** das Gehäuse (1) aus Kunststoff besteht, welcher durch den Zusatz von metallischen Partikeln elektrisch leitfähig gemacht ist,
- **daß** das Gehäuse (1) an mindestens einer seiner Wandungen (5) mindestens ein Stützelement (7) für die dieselbe aufweist, und
- **daß** das Gehäuse (1) aus dem mit den metallischen Partikeln gefüllten Kunststoff durch Spritzgießen in einer den räumlichen Gegebenheiten des Einbauorts im Kraftfahrzeug angepaßten Form hergestellt ist.

2. Anordnung nach Anspruch 1, **dadurch gekennzeichnet, daß** die metallischen Partikel aus Edelstahl, Kupfer oder Zinn bestehen.

3. Anordnung nach Anspruch 1 oder 2, **dadurch gekennzeichnet, daß** die Wandstärke des Gehäuses (1) zwischen 1 mm und 4 mm beträgt.

4. Anordnung nach einem der vorangehenden Ansprüche, **dadurch gekennzeichnet, daß** das Gehäuse (1) aus einem Thermoplast besteht.

## Claims

1. An arrangement for high-voltage components located in a motor vehicle, which has a housing (1) for mounting the high-voltage components, which is completely closable, conductive and suitable for electromagnetically shielding the high-voltage components arranged in the housing (1), and which has openings (8) for the electromagnetically compatible connection of electrical lines to the high-voltage components, **characterized in**
- **that** the housing (1) consists of plastic, which is made electrically conductive by the addition of metallic particles,
- **that** the housing (1) has at least one support element (7) on at least one of its walls for the same, and
- **that** the housing (1) is produced from the plastic filled with the metallic particles by injection molding in a form adapted to the special conditions of the installation location in the motor vehicle.

2. An arrangement according to Claim 1, **characterized in that** the metallic particles consist of stainless steel, copper or tin.

3. An arrangement according to Claim 1 or 2, **characterized in that** the wall thickness of the housing (1) is between 1 mm and 4 mm.

4. An arrangement according to one of the preceding claims, **characterized in that** the housing (1) consist of a thermoplastic.

## Revendications

1. Agencement pour des composants haute tension situés dans un véhicule automobile, qui présente un boîtier (1) qui est destiné à recevoir les composants haute tension et qui peut être entièrement fermé, qui est conducteur et approprié pour blinder de façon électromagnétique les composants haute tension disposés dans le boîtier (1), et qui a des ouvertures (8) pour la connexion, compatible au plan électromagnétique, de lignes électriques aux composants haute tension, **caractérisé en ce que**
- le boîtier (1) se compose de matière plastique qui est rendue électriquement conductrice par l'ajout de particules métalliques,
- le boîtier (1) présente sur au moins une de ses parois (5) au moins un élément de soutien (7) pour celle-ci, et
- **en ce que** le boîtier (1) est, à partir de la matière plastique chargée par les particules métalliques, fabriqué par moulage par injection dans une forme adaptée aux données spatiales du mode de montage dans le véhicule automobile.

2. Agencement selon la revendication 1, **caractérisé en ce que** les particules métalliques se composent d'acier fin, de cuivre ou d'étain.

3. Agencement selon la revendication 1 ou 2, **caractérisé en ce que** l'épaisseur de paroi du boîtier (1) est comprise entre 1 mm et 4 mm.

4. Agencement selon l'une des revendications précédentes, **caractérisé en ce que** le boîtier (1) se compose d'un thermoplastique.
